# EUROPEAN PATENT APPLICATION

(11) **EP 4 585 990 A1**
(43) Date of publication of application: **16.07.2025**
(21) Application number: 23880119.5
(22) Date of filing: 13.10.2023
(51) Int. Cl.: G02B 27/01, G06F 1/20, G06F 1/16

(54) **ELECTRONIC DEVICE COMPRISING STRUCTURE FOR COOLING ELECTRONIC DEVICE**

(30) Priority: 21.10.2022 KR 20220136895; 18.11.2022 KR 20220155855
(71) Applicant: Samsung Electronics Co., Ltd., Suwon-si, Gyeonggi-do 16677 (KR)
(72) Inventor: LEE, Haejin, Suwon-si Gyeonggi-do 16677 (KR)
(74) Representative: Nederlandsch Octrooibureau
(86) International application number: PCT/KR2023/015778
(87) International publication number: WO 2024/085541

(57) **Abstract**

An electronic device according to an embodiment comprises: a printed circuit board including an outer surface on which an electronic component is disposed; an actuator including a first surface facing the outer surface of the printed circuit board, a second surface opposite to the first surface, and a third surface connecting the first surface and the second surface to each other; a first case surrounding at least a part of the third surface and the first surface; a second case coming into contact with the first case; and a heat dissipation chamber sealed by the first case and the second case so as to dissipate heat transferred from the electronic component to the second case, wherein the actuator is configured to transfer air from the outside of the first case toward the first case partially sealing the heat dissipation chamber.

## Description

### [Technical Field]

The present disclosure relates to an electronic device comprising a structure for cooling the electronic device.

### [Background Art]

An electronic device may include various electronic components to meet a need of a user. The electronic device may be miniaturized so as to be worn by the user or carried by the user. As the electronic components disposed in the electronic device perform an operation for responding to a request of the user, heat may be generated in the miniaturized electronic device.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to an embodiment, an electronic device may comprise a printed circuit board including an outer surface on which an electronic component is disposed. According to an embodiment, the electronic device may comprise an actuator including a first surface facing the outer surface of the printed circuit board, a second surface opposite the first surface, and a third surface connecting the first surface and the second surface. According to an embodiment, the electronic device may comprise a first case, spaced apart from the first surface and the third surface, surrounding at least a portion of the first surface and the third surface. According to an embodiment, the electronic device may comprise a second case, disposed between the printed circuit board and the first case, having a portion that contacts the first case. According to an embodiment, the electronic device may comprise a heat dissipation chamber, sealed by the first case and the second case so as to disperse heat transferred from the electronic component to the second case. According to an embodiment, the actuator is configured to deliver air from an outside of the first case toward the first case that partially seals the heat dissipation chamber.

According to an embodiment, an electronic device may comprise a printed circuit board including an outer surface on which an electronic component is disposed. According to an embodiment, the electronic device may comprise an actuator including a first surface facing the outer surface of the printed circuit board, a second surface opposite the first surface, and a third surface connecting the first surface and the second surface. According to an embodiment, the electronic device may comprise a first case including a first coupling portion spaced apart from the first surface and surrounding the first surface, and a second coupling portion connected to the first coupling portion and surrounding at least a portion of the third surface. According to an embodiment, the electronic device may comprise a second case, disposed between the printed circuit board and the first case, having a portion that contacts the first case. According to an embodiment, the electronic device may comprise a heat dissipation chamber sealed by the first case and the second case so as to disperse heat transferred from the electronic component to the second case. According to an embodiment, the electronic device may comprise a cover, including at least one inlet, coupled to the second coupling portion so as to be disposed on the second surface. According to an embodiment, the actuator may vibrate so as to deliver air from an outside of the first case toward the first case that partially seals the heat dissipation chamber.

### [Description of the Drawings]

FIG. 1 is a block diagram of an electronic device within a network environment according to various embodiments.
FIG. 2A is a perspective view of an exemplary electronic device according to an embodiment.
FIG. 2B is an exploded perspective view of an exemplary electronic device according to an embodiment.
FIG. 3A is a perspective view of a heat dissipation structure and a printed circuit board of an exemplary electronic device according to an embodiment.
FIG. 3B is a cross-sectional view illustrating an example of a heat dissipation structure and a printed circuit board of an exemplary electronic device according to an embodiment, cut along line A-A' of FIG. 3A.
FIG. 4 is a cross-sectional view of a heat dissipation structure and a printed circuit board of an exemplary electronic device according to an embodiment.
FIG. 5 is a cross-sectional view of a heat dissipation structure and a printed circuit board of an exemplary electronic device according to an embodiment.
FIG. 6A is a perspective view of an exemplary electronic device according to an embodiment.
FIG. 6B is a cross-sectional view illustrating an example of an exemplary electronic device according to an embodiment, cut along line B-B' of FIG. 6A.

### [Mode for Invention]

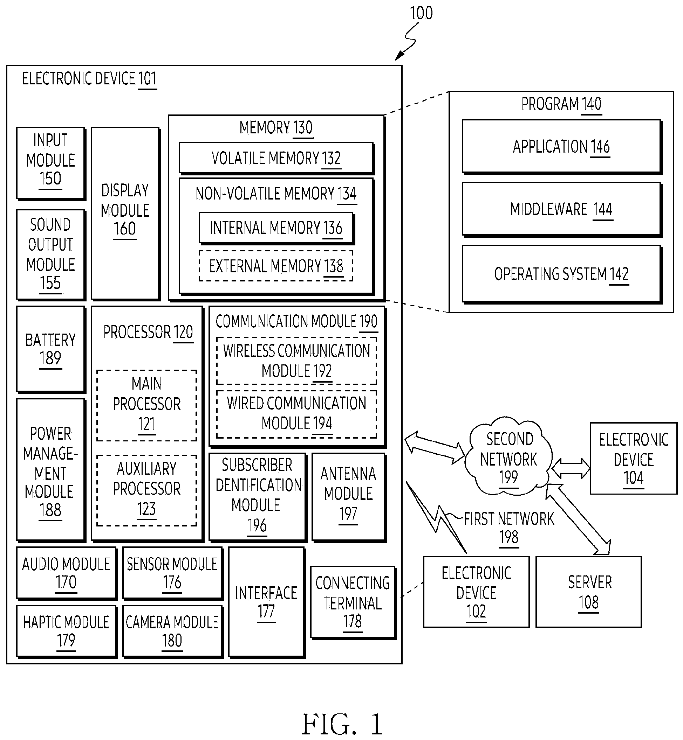

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

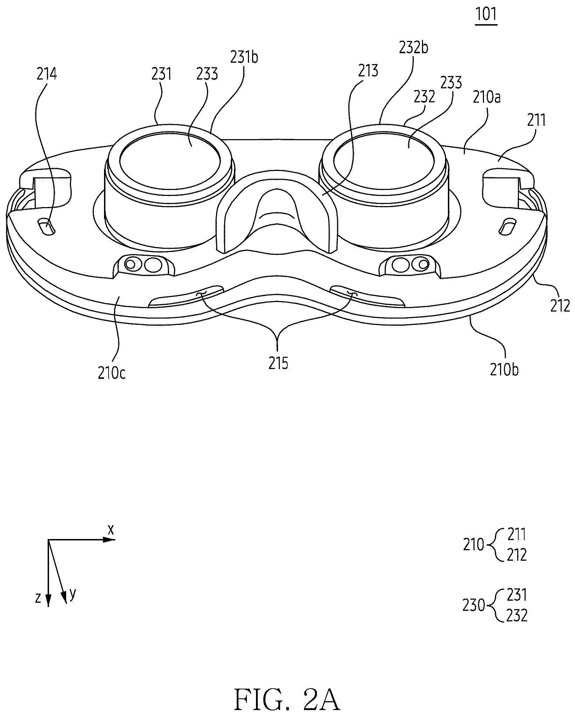

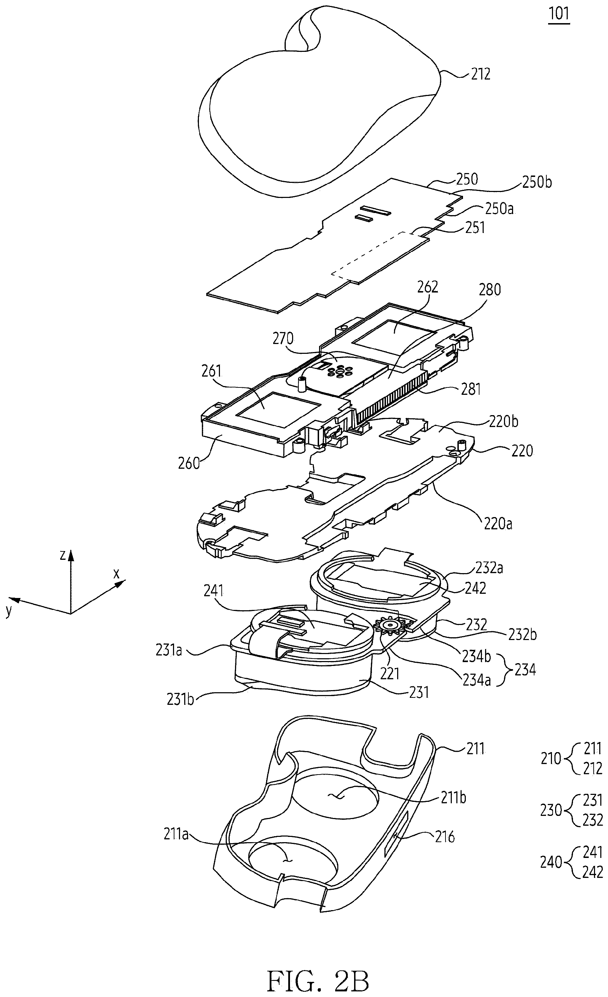

FIG. 2A is a perspective view of an exemplary electronic device according to an embodiment, and FIG. 2B is an exploded perspective view of an exemplary electronic device according to an embodiment.

Referring to FIGS. 2A and 2B, according to an embodiment, an electronic device 101 (e.g., the electronic device 101 of FIG. 1) may include a housing 210, a first bracket 220, at least one moving flange 230, at least one display 240, a printed circuit board 250, a second bracket 260, a fan 270, and/or a heat sink 280. According to an embodiment, the electronic device 101 may be referred to as a wearable device worn on a portion of a body of a user. The electronic device 101 may be configured to provide augmented reality (AR), virtual reality (VR), or mixed reality (MR) that combines the augmented reality and the virtual reality to the user. For example, the electronic device 101 may be configured to provide the virtual reality through the at least one display 240 based on receiving data on an image from an outside of the electronic device 101. For example, the image provided by the electronic device 101 may include a still image and/or a video for implementing the virtual reality. For example, the electronic device 101 may be configured to provide the augmented reality through the at least one display 240 that displays a real image provided by light received from the outside of the electronic device 101 and a virtual object overlapping the real image. The real image may mean an image or a video implemented by the light received from the outside of the electronic device 101 without separate data processing by the electronic device 101. The virtual object may include at least one of text and an image corresponding to various information related to an object included in the real image. However, it is not limited thereto, and the virtual object may include at least one of the text and the image corresponding to various information related to another object distinguished from the object included in the real image.

The housing 210 may define at least a portion of an outer surface of the electronic device 101. The housing 210 may accommodate various components of the electronic device 101. The housing 210 may provide a space in which various components of the electronic device 101 are disposed. According to an embodiment, when the electronic device 101 is worn by the user, a rear surface 210a of the housing 210 may face a portion of the body of the user. For example, the housing 210 may include the rear surface 210a, a front surface 210b, and/or a lateral surface 210c. When the electronic device 101 is worn on a head of the user, the rear surface 210a of the housing 210 may face a face of the user. The front surface 210b of the housing 210 may be opposite to the rear surface 210a of the housing 210. The front surface 210b may be spaced apart from the rear surface 210a. A direction (e.g., a +z direction) toward which the front surface 210b faces may face a direction opposite to a direction (e.g., a -z direction) toward which the rear surface 210a faces. For example, the direction toward which the front surface 210b faces may be substantially parallel to a gaze direction of the user when the electronic device 101 is worn on the user. According an embodiment, the lateral surface 210c of the housing 210 may connect the rear surface 210a and the front surface 210b. The lateral surface 210c may extend between the rear surface 210a and the front surface 210b. The lateral surface 210c may surround a periphery of the rear surface 210a and a periphery of the front surface 210b. According to an embodiment, the lateral surface 210c of the housing 210 may have curvature and may be bent, but is not limited thereto. For example, the lateral surface 210c may be substantially perpendicular to the rear surface 210a and the front surface 210b.

According to an embodiment, the housing 210 may include a first portion 211 and a second portion 212. The first portion 211 and the second portion 212 may define (or form) the housing 210 by being coupled to each other. The first portion 211 may define the rear surface 210a of the housing 210. According to an embodiment, the first portion 211 may include a first driving hole 211a and a second driving hole 211b. The first driving hole 211a and the second driving hole 211b may define a space in which at least one moving flange 230 may move. For example, the first driving hole 211a may define a space in which a first moving flange 231 may move. For example, the second driving hole 211b may define a space in which a second moving flange 232 may move. According to an embodiment, the first driving hole 211a and the second driving hole 211b may penetrate the first portion 211. The first driving hole 211a and the second driving hole 211b may be spaced apart from each other. According to an embodiment, a size of each of the first driving hole 211a and the second driving hole 211b may be larger than a size of each of the first moving flange 231 and the second moving flange 232. For example, a cross-sectional area of each of the first driving hole 211a and the second driving hole 211b may be larger than a size of the cross-sectional area of each of the first moving flange 231 and the second moving flange 232. The second portion 212 may define the front surface 210b of the housing 210. According to an embodiment, the lateral surface 210c of the housing 210 may be defined by coupling of the first portion 211 and the second portion 212.

According to an embodiment, the housing 210 may include a nose pad 213. The nose pad 213 may support the electronic device 101 by contacting the portion of the body of the user when the electronic device 101 is worn by the user. The nose pad 213 may have a shape corresponding to a shape of a portion of the body of the user. For example, the nose pad 213 may contact a nose of the user when the electronic device 101 is worn on the head of the user. According to an embodiment, the electronic device 101 may have a symmetrical structure based on the nose pad 213.

According to an embodiment, the housing 210 may include a first inlet 214, a second inlet 215, and an outlet 216. The first inlet 214 may connect the outside of the housing 210 and the inside of the housing 210. The first inlet 214 may deliver air from the outside of the housing 210 to the inside of the housing 210. According to an embodiment, the first inlet 214 may penetrate the rear surface 210a of the housing 210. The first inlet 214 may be disposed on the rear surface 210a. The number of first inlets 214 may be one or more. The second inlet 215 may connect the outside of the housing 210 and the inside of the housing 210. The second inlet 215 may deliver air from the outside of the housing 210 to the inside of the housing 210. According to an embodiment, the second inlet 215 may penetrate the lateral surface 210c of the housing 210. The second inlet 215 may be disposed on the lateral surface 210c. The number of second inlets 215 may be one or more. The outlet 216 may connect the outside of the housing 210 and the inside of the housing 210. The outlet 216 may deliver air from the inside of the housing 210 to the outside of the housing 210. For example, the outlet 216 may deliver the air that has passed through the heat sink 280 to the outside of the housing 210. According to an embodiment, at least a portion of the outlet 216 may overlap the heat sink 280 when the housing 210 is viewed from above (e.g., a -y direction). For example, the outlet 216 may penetrate the lateral surface 210c of the housing 210. For example, the outlet 216 may be disposed on the lateral surface 210c of the housing 210. The number of outlets 216 may be one or more.

According to an embodiment, the first bracket 220 may support a portion of the components of the electronic device 101 in the housing 210. According to an embodiment, the first bracket 220 may be disposed within the housing 210. For example, the first bracket 220 may be disposed between the at least one moving flange 230 and the second bracket 260. According to an embodiment, a surface 220a of the first bracket 220 may face the at least one display 240. Another surface 220b of the first bracket 220 may be opposite to the surface 220a of the first bracket 220. A direction (e.g., the +z direction) in which the another surface 220b of the first bracket 220 faces may be opposite to a direction (e.g., the -z direction) in which the surface 220a of the first bracket 220 faces. The another surface 220b of the first bracket 220 may be spaced apart from the surface 220a of the first bracket 220.

According to an embodiment, the electronic device 101 may include a pinion gear 221 coupled to the first bracket 220. The pinion gear 221 may be rotatable with respect to the first bracket 220. The pinion gear 221 may include a plurality of gear teeth. The pinion gear 221 may face the surface 220a of the first bracket 220. The pinion gear 221 may be disposed on the surface 220a of the first bracket 220. When an element is referred to as being "on" another element, it should be understood that it may be directly on the another element, or there may be intervening elements therebetween. In contrast, when an element is referred to as being "directly on" another element, no intervening elements exist.

The at least one moving flange 230 may be coupled to the housing 210 to be movable with respect to the housing 210. For example, the at least one moving flange 230 may be movable with respect to the first bracket 220 in the housing 210. According to an embodiment, the at least one moving flange 230 may include the first moving flange 231 and the second moving flange 232. The first moving flange 231 may pass through the first driving hole 211a. For example, the first moving flange 231 may pass through the first driving hole 211a by extending from the inside of the housing 210. The second moving flange 232 may pass through the second driving hole 211b. For example, the second moving flange 232 may pass through the second driving hole 211b by extending from the inside of the housing 210. According to an embodiment, a portion of the at least one moving flange 230 may be disposed in the housing 210. For example, a portion of the at least one moving flange 230 may be coupled to the at least one display 240 in the housing 210. For example, a portion 231a of the first moving flange 231 may be coupled to a first display 241 of the at least one display 240 in the housing 210. For example, a portion 232a of the second moving flange 232 may be coupled to a second display 242 of the at least one display 240 in the housing 210. According to an embodiment, a portion of the moving flange 230 may face the first bracket 220. For example, the portion 231a of the first moving flange 231 may face the surface 220a of the first bracket 220. For example, the portion 232a of the second moving flange 232 may face the surface 220a of the first bracket 220. According to an embodiment, another portion of the moving flange 230 may be disposed outside the housing 210. For example, another portion 231b of the first moving flange 231 may be disposed outside the housing 210. For example, another portion 232b of the second moving flange 232 may be disposed outside the housing 210. According to an embodiment, the another portion 231b of the first moving flange 231 may protrude to the outside of the housing 210. For example, the another portion 231b of the first moving flange 231 may penetrate the first driving hole 211a. For example, the another portion 231b of the first moving flange 231 may be disposed outside the first driving hole 211a. According to an embodiment, the another portion 232b of the second moving flange 232 may protrude to the outside of the housing 210. For example, the another portion 232b of the second moving flange 232 may penetrate the second driving hole 211b. For example, the another portion 232b of the second moving flange 232 may be disposed outside the second driving hole 211b.

According to an embodiment, the at least one moving flange 230 may include a lens 233. The lens 233 may refract light discharged from the at least one display 240 so that the electronic device 101 may provide virtual reality. According to an embodiment, the lens 233 may be coupled to other portions 231b and 232b of the at least one moving flange 230 disposed outside the housing 210. The lens 233 may face the body of the user when the electronic device 101 is worn on the user. For example, a position of the lens 233 may correspond to a position of eyes of the user when the electronic device 101 is worn on the head of the user. According to an embodiment, the lens 233 may include a plurality of lenses disposed on each of the first moving flange 231 and the second moving flange 232.

According to an embodiment, the at least one moving flange 230 may include a rack gear 234. The rack gear 234 may include a plurality of gear teeth. The rack gear 234 may be engaged with the pinion gear 221. The plurality of gear teeth of the rack gear 234 may be engaged with the plurality of gear teeth of the pinion gear 221. In an embodiment, the rack gear 234 may be disposed in the housing 210. For example, the rack gear 234 may be disposed on portions 231a and 232a of the at least one moving flange 230. According to an embodiment, the rack gear 234 may include a first rack gear 234a and a second rack gear 234b. The first rack gear 234a may be coupled to the first moving flange 231. The second rack gear 234b may be coupled to the second moving flange 232. According to an embodiment, the rack gear 234 may have a shape extending in a direction (e.g., a +x direction or a -x direction) substantially parallel to the surface 220a of the first bracket 220. For example, the first rack gear 234a and the second rack gear 234b may be substantially parallel to the surface 220a of the first bracket 220.

The at least one display 240 may be configured to provide visual information. For example, the at least one display 240 may be configured to discharge light based on receiving data for displaying an image from a processor (e.g., the processor 120 of FIG. 1). According to an embodiment, the at least one display 240 may be electrically connected to the printed circuit board 250. For example, the at least one display 240 may be electrically connected to the printed circuit board 250 through a flexible printed circuit board. According to an embodiment, the at least one display 240 may be coupled to the at least one moving flange 230. For example, the at least one display 240 may be disposed on the portions 231a and 232a of the at least one moving flange 230 disposed inside the housing 210. According to an embodiment, the at least one display 240 may include the first display 241 and the second display 242. The first display 241 may be coupled to the first moving flange 231. The first display 241 may face the surface 220a of the first bracket 220. The first display 241 may be spaced apart from the surface 220a of the first bracket 220. The second display 242 may be coupled to the second moving flange 232. The second display 242 may face the surface 220a of the first bracket 220. The second display 242 may be spaced apart from the surface 220a of the first bracket 220.

According to an embodiment, the at least one display 240 may be movable in the housing 210. The at least one display 240 may be movable with respect to the first bracket 220. For example, the at least one display 240 may be movable on the surface 220a of the first bracket 220. For example, the at least one display 240 may be movable in a direction substantially parallel to the surface 220a of the first bracket 220. According to an embodiment, the second display 242 may move in a direction (e.g., the -x direction) closer to the first display 241 or may move in a direction (e.g., the +x direction) away from the first display 241. According to an embodiment, the at least one display 240 may be movable with respect to the first bracket 220 by movement of the at least one moving flange 230 with respect to the first bracket 220. For example, the user may move the at least one moving flange 230 through the other portions 231b and 232b of the at least one moving flange 230. A distance between the first display 241 and the second display 242 may be decreased or increased by movement of the first moving flange 231 and the second moving flange 232. For example, the pinion gear 221 engaged with the first rack gear 234a may rotate in case that the first moving flange 231 moves in a direction (e.g., the +x direction) closer to the second moving flange 232 by external force of the user. By rotation of the pinion gear 221, the second rack gear 234b engaged with the pinion gear 221 may move in a direction (e.g., the -x direction) closer to the first moving flange 231. As the first moving flange 231 moves in the direction closer to the second moving flange 232 and the second moving flange 232 moves in the direction closer to the first moving flange 231, the distance between the first display 241 and the second display 242 may be decreased. For example, in case that the first moving flange 231 moves in a direction (e.g., the -x direction) away from the second moving flange 232 by the external force of the user, the pinion gear 221 engaged with the first rack gear 234a may rotate. By the rotation of the pinion gear 221, the second rack gear 234b engaged with the pinion gear 221 may move in a direction (e.g., the +x direction) away from the first moving flange 231. As the first moving flange 231 moves in the direction away from the second moving flange 232 and the second moving flange 232 moves in the direction away from the first moving flange 231, the distance between the first display 241 and the second display 242 may increase. The distance between the first display 241 and the second display 242 may correspond to an inter-pupillary distance of the user. As the distance between the first display 241 and the second display 242 is adjusted to correspond to the inter-pupillary distance of the user, the electronic device 101 may provide three-dimensional virtual reality to the user.

According to an embodiment, the printed circuit board 250 may form an electrical connection between the components in the electronic device 101. For example, the printed circuit board 250 may form an electrical connection between the electronic components disposed on a first outer surface 250a of the printed circuit board 250, or a second outer surface 250b of the printed circuit board 250 opposite to the first outer surface 250a of the printed circuit board 250. The printed circuit board 250 may form an electrical connection between other electronic components disposed outside the printed circuit board 250. The printed circuit board 250 may form an electrical connection between the electronic components (e.g., the processor 120 of FIG. 1) disposed on the first outer surface 250a of the printed circuit board 250 and the other electronic components disposed outside the printed circuit board 250. For example, the printed circuit board 250 may be electrically connected to the at least one display 240. According to an embodiment, the printed circuit board 250 may be disposed in the housing 210. For example, the printed circuit board 250 may be disposed on the another surface 220b of the first bracket 220. For example, the printed circuit board 250 may be spaced apart from the another surface 220b of the first bracket 220 along a direction (e.g., the +z direction) in which the another surface 220b of the first bracket 220 faces. The first outer surface 250a of the printed circuit board 250 may face the second bracket 260.

According to an embodiment, the second bracket 260 may support another portion of the components of the electronic device 101. For example, the second bracket 260 may support a first battery 261 and a second battery 262. The first battery 261 may be coupled to the second bracket 260. The second battery 262 may be coupled to the second bracket 260 by being spaced apart from the first battery 261. According to an embodiment, the second bracket 260 may surround the first battery 261 and the second battery 262. The first battery 261 and the second battery 262 may be electrically connected to the printed circuit board 250. According to an embodiment, the second bracket 260 may be disposed in the housing 210. For example, the second bracket 260 may be disposed between the printed circuit board 250 and the first bracket 220.

According to an embodiment, the fan 270 may generate airflow for cooling the housing 210 and components positioned inside the housing 210. For example, the fan 270 may generate the airflow to introduce air outside the housing 210 into the inlets 214 and 215 of the housing 210. The fan 270 may generate the airflow for discharging air inside the housing 210 to the outlet 216 of the housing 210. According to an embodiment, the fan 270 may be electrically connected to the printed circuit board 250. The fan 270 may be electrically connected to at least one of the first battery 261 and the second battery 262. The fan 270 may receive power from at least one of the first battery 261 and the second battery 262. According to an embodiment, the fan 270 may be coupled to the second bracket 260. For example, the fan 270 may be disposed between the first battery 261 and the second battery 262. According to an embodiment, the fan 270 may be disposed between the printed circuit board 250 and the first bracket 220. The fan 270 may face the first bracket 220.

According to an embodiment, the heat sink 280 may discharge heat generated from the printed circuit board 250 to the outside of the housing 210. For example, a plurality of pins 281 for increasing a surface area of the inside of the heat sink 280 may be included. According to an embodiment, the heat sink 280 may face the first outer surface 250a of the printed circuit board 250. For example, the heat sink 280 may face a portion (e.g., the processor 120 of FIG. 1) of the electronic components disposed on the first outer surface 250a of the printed circuit board 250. According to an embodiment, a region 251 of the printed circuit board 250 may face the heat sink 280. For example, the region 251 of the printed circuit board 250 may at least partially overlap the heat sink 280 when the printed circuit board 250 is viewed vertically (e.g., the +z direction or the -z direction). According to an embodiment, electronic components having a relatively high calorific value among a plurality of electronic components disposed in the printed circuit board 250 may be disposed in the region 251 of the printed circuit board 250. For example, an electronic component disposed in the region 251 of the printed circuit board 250 may include the processor 120. As the heat sink 280 faces the region 251 of the printed circuit board 250, the heat generated from the electronic components of the printed circuit board 250 may be discharged to the outside of the housing 210.

According to an embodiment, the heat sink 280 may pass the airflow generated by the fan 270. The heat sink 280 may discharge the heat transferred from the airflow generated by the fan 270 to the outside of the housing 210. According to an embodiment, the heat sink 280 may be coupled to the second bracket 260. For example, the heat sink 280 may be disposed between the first battery 261 and the second battery 262. According to an embodiment, the heat sink 280 may at least partially overlap the fan 270 when the housing 210 is viewed from above (e.g., the -y direction).

According to an embodiment, air outside the housing 210 may be introduced into the inside of the housing 210 through the inlets 214 and 215 by the airflow generated through the fan 270. The air introduced into the housing 210 through the inlets 214 and 215 may be delivered to the components (e.g., the at least one display 240 and/or the printed circuit board 250) in the housing 210. The heat generated in the housing 210 may be transferred to the air introduced into the housing 210. The air heated in the housing 210 may move to the fan 270. As the air is discharged to the outside of the housing 210 by passing through the heat sink 280 and the outlet 216, the inside of the housing 210 may be cooled.

For example, in case that the components with the relatively high calorific value are disposed in the region 251 of the printed circuit board 250, the electronic device 101 may need a structure for dispersing heat, since performance of the electronic device 101 may be decreased in case that the heat is concentrated inside the electronic device 101. In case that a component (e.g., the fan 270 or the heat sink 280) for cooling the electronic device 101 and a structure for dispersing heat in the electronic device 101 are disposed together inside the electronic device 101, a space of the inside of the electronic device 101 in which the components may be disposed may be decreased. Hereinafter, a structure capable of dispersing and/or cooling the heat in the electronic device 101 while securing the space in which components may be disposed will be described.

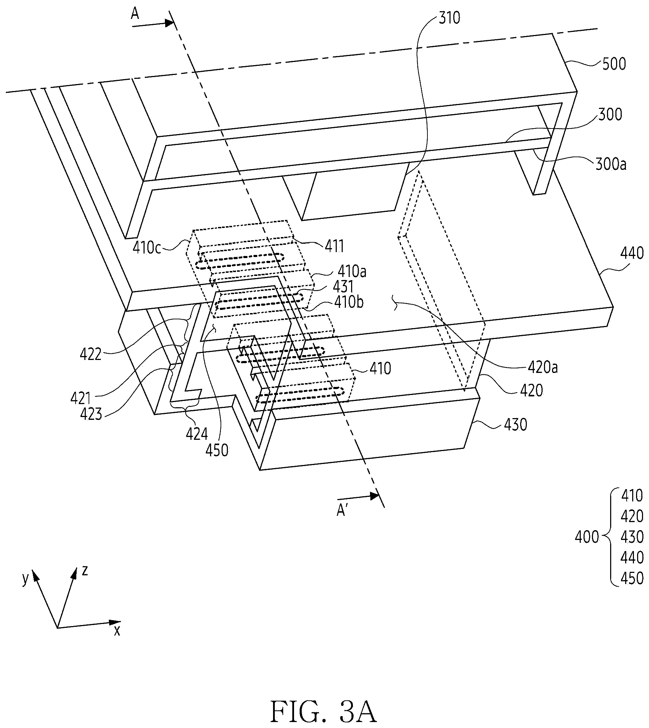

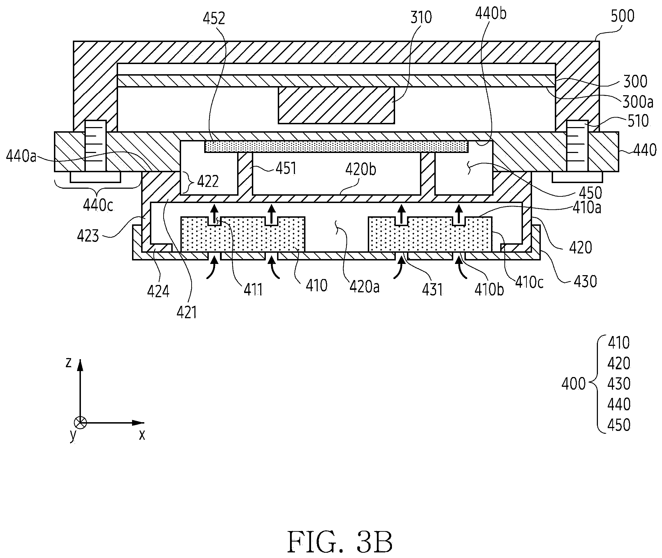

FIG. 3A is a perspective view of a heat dissipation structure and a printed circuit board of an exemplary electronic device according to an embodiment, and FIG. 3B is a cross-sectional view illustrating an example of a heat dissipation structure and a printed circuit board of an exemplary electronic device according to an embodiment, cut along line A-A' of FIG. 3A.

Referring to FIGS. 3A and 3B, the electronic device (e.g., the electronic device 101 of FIGS. 1, 2A, and/or 2B) according to an embodiment may include a printed circuit board 300 (e.g., the printed circuit board 250 of FIG. 2B), a heat dissipation structure 400, and/or a support portion 500.

According to an embodiment, the printed circuit board 300 may establish an electrical connection between electronic components. The printed circuit board 300 may support at least one electronic component 310. For example, the at least one electronic component 310 may be disposed on an outer surface 300a (e.g., the first outer surface 250a and/or the second outer surface 250b of FIG. 2B) of the printed circuit board 300. For example, the at least one electronic component 310 may be attached to the outer surface 300a of the printed circuit board 300.

According to an embodiment, the heat dissipation structure 400 may cool heat generated from the at least one electronic component 310 of the printed circuit board 300. For example, the heat dissipation structure 400 may disperse the heat generated from the at least one electronic component 310 into an inside of the electronic device 101. For example, the heat dissipation structure 400 may generate airflow for discharging the heat generated from the at least one electronic component 310 to an outside of the electronic device 101. According to an embodiment, the heat dissipation structure 400 may include at least one actuator 410, a first case 420, a cover 430, a second case 440, and/or a heat dissipation chamber 450.

The at least one actuator 410 may generate airflow through air introduced from an outside of the first case 420 to cool the heat dissipation chamber 450. The at least one actuator 410 may discharge the air introduced from the outside of the first case 420 through a first surface 410a. The first surface 410a of the at least one actuator 410 may face the outer surface 300a of the printed circuit board 300. For example, a direction (e.g., a +z direction) in which the first surface 410a faces may be opposite to a direction (e.g., a -z direction) in which the outer surface 300a of the printed circuit board 300 faces. According to an embodiment, the at least one actuator 410 may include at least one nozzle 411 for discharging the air introduced from the outside of the first case 420. The at least one nozzle 411 may be disposed on the first surface 410a. For example, the at least one nozzle 411 may penetrate the first surface 410a. According to an embodiment, the at least one actuator 410 may discharge the air for cooling the first case 420 by vibrating. For example, the at least one actuator 410 may include a flexible micro-electro mechanical system (MEMS), but is not limited thereto. The at least one actuator 410 may vibrate along the direction (e.g., the +z direction) in which the first surface 410a faces and/or a direction (e.g., the -z direction) in which a second surface 410b opposite to the first surface 410a faces. The second surface 410b may face the cover 430. According to an embodiment, a third surface 410c of the at least one actuator 410 may connect the first surface 410a and the second surface 410b. For example, the third surface 410c may extend from the first surface 410a to the second surface 410b. For example, the third surface 410c may surround a periphery of the first surface 410a and a periphery of the second surface 410b. The third surface 410c may be substantially perpendicular to the first surface 410a and/or the second surface 410b, but is not limited thereto. For example, the third surface 410c may be bent to have curvature with respect to the first surface 410a and/or the second surface 410b. For example, the at least one actuator 410 may have a frequency of approximately 20 kHz or more, but is not limited thereto. According to an embodiment, the at least one actuator 410 may include a plurality of actuators. The plurality of actuators may be spaced apart from each other, but are not limited thereto. For example, the plurality of actuators may be in contact with each other or may be stacked to each other.

According to an embodiment, the first case 420 may define a duct 420a capable of guiding movement of the airflow generated from the at least one actuator 410. The duct 420a may surround at least a portion of the first surface 410a, the second surface 410b, and the third surface 410c in an inside of the first case 420. The duct 420a may connect the inside of the first case 420 and the outside of the first case 420. The airflow generated from the at least one actuator 410 may move to the outside of the first case 420 by moving along the duct 420a in the first case 420. Although in FIG. 3A, the duct 420a is illustrated in a shape extending in the +x-axis direction, this is for convenience of a description. For example, the duct 420a may extend along the -x-axis direction. For example, the duct 420a may extend along a +y-axis direction. For example, the duct 420a may extend along a -y-axis direction.

According to an embodiment, the first case 420 may partially seal the heat dissipation chamber 450. For example, as the first case 420 contacts the second case 440, the first case 420 may seal the heat dissipation chamber 450. According to an embodiment, the first case 420 may be disposed around the at least one actuator 410. The first case 420 may surround the at least one actuator 410. For example, the first case 420 may surround at least a portion of the first surface 410a and the third surface 410c. The first case 420 may cover the at least one actuator 410. For example, the first case 420 may surround at least a portion of the first surface 410a and the third surface 410c. According to an embodiment, the first case 420 may be spaced apart from at least a portion of the at least one actuator 410. For example, the first case 420 may be spaced apart from at least a portion of the first surface 410a and/or the third surface 410c of the at least one actuator 410. According to an embodiment, the first case 420 may include a first coupling portion 421, a second coupling portion, a third coupling portion 423, and/or a fourth coupling portion 424.

According to an embodiment, the first coupling portion 421 may be disposed between the at least one actuator 410 and the heat dissipation chamber 450. For example, the first coupling portion 421 may be disposed between the duct 420a and the heat dissipation chamber 450. The first coupling portion 421 may be in contact with the duct 420a and the heat dissipation chamber 450. According to an embodiment, the first coupling portion 421 may be disposed above the first surface 410a of the at least one actuator 410. The first coupling portion 421 may be spaced apart from the first surface 410a in the direction (e.g., the +z direction) in which the first surface 410a faces. A portion of the first coupling portion 421 may cover the first surface 410a. According to an embodiment, the first coupling portion 421 may be substantially parallel to the first surface 410a. For example, the first coupling portion 421 may extend in a direction substantially parallel to the first surface 410a.

According to an embodiment, the second coupling portion 422 may seal the heat dissipation chamber 450. For example, the second coupling portion 422 may surround the heat dissipation chamber 450. According to an embodiment, the second coupling portion 422 may be connected to the first coupling portion 421. The second coupling portion 422 may be disposed on the first coupling portion 421. The second coupling portion 422 may extend from the first coupling portion 421. For example, the second coupling portion 422 may extend from the first coupling portion 421 along the direction (e.g., the +z direction) in which the first surface 410a faces. According to an embodiment, the second coupling portion 422 may be in contact with a portion 440a of the second case 440. For example, the second coupling portion 422 may extend from the first coupling portion 421 to the second case 440 along a direction substantially perpendicular to the second case 440.

According to an embodiment, the third coupling portion 423 may enclose the duct 420a. The third coupling portion 423 may surround the duct 420a. According to an embodiment, the third coupling portion 423 may be connected to the first coupling portion 421. The third coupling portion 423 may extend from the first coupling portion 421. The third coupling portion 423 may be substantially perpendicular to the first coupling portion 421. For example, the third coupling portion 423 may extend from the first coupling portion 421 in the direction (e.g., the -z direction) in which the second surface 410b faces. According to an embodiment, the third coupling portion 423 may surround at least a portion of the third surface 410c.

According to an embodiment, the fourth coupling portion 424 may be connected to the third coupling portion 423. For example, the fourth coupling portion 424 may be connected to the third coupling portion 423 substantially vertically. The fourth coupling portion 424 may extend from the third coupling portion 423. The fourth coupling portion 424 may be substantially parallel to the first coupling portion 421. For example, the fourth coupling portion 424 may face the first coupling portion 421 and may be spaced apart from the first coupling portion 421. According to an embodiment, the third coupling portion 423 and the fourth coupling portion 424 may be at least partially surrounded by the cover 430. For example, the third coupling portion 423 and the fourth coupling portion 424 may be in contact with the cover 430.

According to an embodiment, the cover 430 may define the duct 420a together with the first case 420. For example, the cover 430 may be coupled to the first case 420 to be disposed on the second surface 410b. For example, the cover 430 may be in contact with a portion of the third coupling portion 423 and the fourth coupling portion 424. According to an embodiment, the cover 430 may include at least one inlet 431. The at least one inlet 431 may penetrate the cover 430. For example, the at least one inlet 431 may connect the outside of the first case 420 and the inside of the first case 420. The air of the outside of the first case 420 may be introduced into the inside of the first case 420 through the at least one inlet 431.

According to an embodiment, the second case 440 may seal the heat dissipation chamber 450 together with the first case 420. For example, the second case 440 may be disposed on the heat dissipation chamber 450. For example, the portion 440a of the second case 440 may seal the heat dissipation chamber 450 by contacting the first case 420. For example, the first case 420 and the second case 440 may seal the heat dissipation chamber 450 by being welded, but are not limited thereto. The second case 440 may transfer the heat from the at least one electronic component 310 of the printed circuit board 300 to the heat dissipation chamber 450. According to an embodiment, the second case 440 may be disposed between the printed circuit board 300 and the first case 420. For example, the second case 440 may be spaced apart from the printed circuit board 300. In case that the second case 440 and the printed circuit board 300 are spaced apart from each other, a thermally conductive material (e.g., a thermal interface material (TIM)) may be disposed between the second case 440 and the printed circuit board 300. However, it is not limited thereto. For example, the second case 440 may be in contact with the printed circuit board 300.

According to an embodiment, the heat dissipation chamber 450 may disperse the heat transferred from the at least one electronic component 310 to the second case 440. For example, the heat dissipation chamber 450 may disperse the heat transferred to the second case 440 in a direction (e.g., a +x direction and/or a -x direction) in which the third surface 410c faces. According to an embodiment, the heat dissipation chamber 450 may be disposed between the first case 420 and the second case 440. For example, the heat dissipation chamber 450 may be defined between a first chamber surface 420b of the first case 420 and a second chamber surface 440b of the second case 440. The first chamber surface 420b may be disposed inside the heat dissipation chamber 450. The first chamber surface 420b may face the direction (e.g., the +z direction) substantially parallel to the direction in which the first surface 410a faces. The first chamber surface 420b may face the outer surface 300a of the printed circuit board 300. The second chamber surface 440b may be disposed inside the heat dissipation chamber 450. For example, the second chamber surface 440b may face the first chamber surface 420b. For example, a direction (e.g., a - z direction) in which the second chamber surface 440b faces may be opposite to the direction (e.g., the +z direction) in which the first chamber surface 420b faces.

According to an embodiment, the heat dissipation chamber 450 may include a fluid placed inside the heat dissipation chamber 450, a protrusion 451, and/or an absorbing member 452. The fluid in the heat dissipation chamber 450 may be vaporizable by the heat transferred from the at least one electronic component 310. For example, air pressure of the inside of the heat dissipation chamber 450 may be lower than atmospheric pressure. For example, the air pressure of the inside of the heat dissipation chamber 450 may be substantially in a vacuum state. The fluid in the heat dissipation chamber 450 may be, for example, water, but is not limited thereto. The protrusion 451 may maintain a shape of the heat dissipation chamber 450. For example, the protrusion 451 may support the second chamber surface 440b to reduce damage to the heat dissipation chamber 450 due to the air pressure of the inside of the heat dissipation chamber 450. According to an embodiment, the protrusion 451 may be disposed on the first chamber surface 420b. For example, the protrusion 451 may protrude from the first chamber surface 420b. For example, the protrusion 451 may extend from the first chamber surface 420b along the direction (e.g., the +z direction) in which the first chamber surface 420b faces. According to an embodiment, the protrusion 451 may support the absorption member 452. For example, the protrusion 451 may be in contact with the absorption member 452. However, it is not limited thereto. For example, the protrusion 451 may be in contact with the second chamber surface 440b by penetrating the absorption member 452. The absorption member 452 may transfer the fluid in the heat dissipation chamber 450 to the second chamber surface 440b close to the at least one electronic component 310. For example, the absorption member 452 may include a porous structure for absorbing the fluid in the heat dissipation chamber 450, but is not limited thereto. The absorption member 452 may be disposed inside the heat dissipation chamber 450. For example, the absorption member 452 may be disposed on the second chamber surface 440b. For example, the absorption member 452 may be in contact with the second chamber surface 440b. When the heat from the at least one electronic component 310 is transferred to the absorption member 452, the fluid in the absorption member 452 may be vaporized. As the fluid vaporized from the absorption member 452 diffuses into the inside of the heat dissipation chamber 450, the heat from the at least one electronic component 310 may be dispersed. The at least one actuator 410 may deliver the air introduced through the at least one inlet 431 to the first case 420 to cool the heat dissipation chamber 450. As the first case 420 is cooled by the airflow generated by the at least one actuator 410, the fluid in the heat dissipation chamber 450 adjacent to the first chamber surface 420b may be cooled. The fluid in the heat dissipation chamber 450 liquefied by being cooled may be absorbed by the absorption member 452. According to an embodiment, the airflow generated by the at least one actuator 410 may move to the outside of the first case 420 by moving along the duct 420a after contacting the first case 420. The air moved to the outside of the first case 420 may move to the outside of the electronic device 101 along an outlet (e.g., the outlet 216 of FIG. 2B).

According to an embodiment, the support portion 500 may support the printed circuit board 300 in the electronic device 101. The support portion 500 may accommodate the printed circuit board 300. For example, the support portion 500 may enclose the printed circuit board 300. For example, the support portion 500 may surround the printed circuit board 300. According to an embodiment, the support portion 500 may be disposed on the heat dissipation structure 400. For example, the support portion 500 may be disposed on the second case 440. According to an embodiment, the support portion 500 may be coupled to the second case 440 through a fastening member 510. The fastening member 510 may penetrate the support portion 500 and the second case 440. For example, the fastening member 510 may penetrate another portion 440c of the second case 440. The another portion 440c of the second case 440 may be spaced apart from the portion 440a of the second case 440 in contact with the first case 420. The another portion 440c of the second case 440 may be disposed outside the first case 420. According to an embodiment, the fastening member 510 may not penetrate the first case 420. For example, the fastening member 510 may be disposed outside the first case 420. Meanwhile, in FIGS. 3A and 3B, it is illustrated that the support portion 500 supports only the printed circuit board 300, but is not limited thereto. For example, the support portion 500 may be a portion of a housing (e.g., the housing 210 of FIG. 2A and FIG. 2B), a first bracket (e.g., the first bracket 220 of FIG. 2B), and a second bracket (e.g., the second bracket 260 of FIG. 2B) supporting the entire printed circuit board 300 and the heat dissipation structure 400.

As described above, according to an embodiment, the electronic device 101 may provide a structure capable of securing a space in which components in the electronic device 101 are disposed while cooling the electronic device 101 by the first case 420 forming the duct 420a and partially sealing the heat dissipation chamber 450. For example, in case that the duct 420a is omitted, the airflow discharged from the at least one actuator 410 may not move smoothly to the outside of the electronic device 101. In case that the heat dissipation chamber 450 is not sealed, amount of the fluid in the heat dissipation chamber 450 vaporized by the heat transferred from the at least one electronic component 310 may be decreased. In case that the amount of the fluid vaporized in the heat dissipation chamber 450 is decreased, performance of the at least one electronic component 310 may be decreased, as the heat discharged from the at least one electronic component 310 is not dispersed and is concentrated in a region of the printed circuit board 300. For example, in case that a component to form the duct 420a and a component to partially seal the heat dissipation chamber 450 are different, a space in the electronic device 101 may be wasted. According to an embodiment, the electronic device 101 may provide a structure capable of securing a space in which components in the electronic device 101 may be disposed, since the first case 420 partially seals the heat dissipation chamber 450 while providing the duct 420a guiding movement of the airflow.

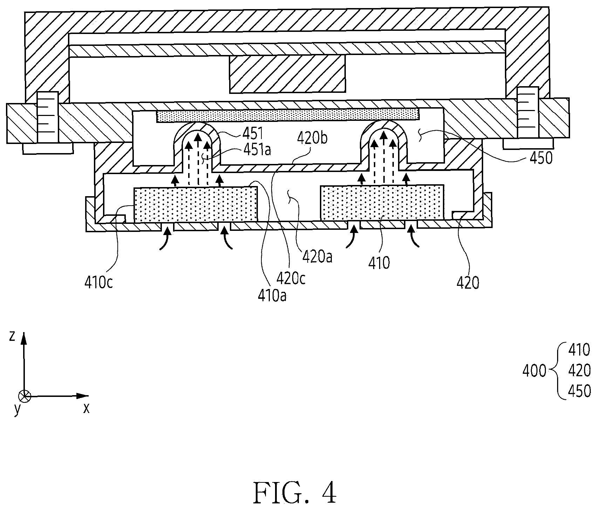

FIG. 4 is a cross-sectional view of a heat dissipation structure and a printed circuit board of an exemplary electronic device according to an embodiment.

Since a heat dissipation structure 400 of FIG. 4 may be a heat dissipation structure 400 in which a shape of the protrusion 451 in the heat dissipation structure 400 of FIGS. 3A and 3B is changed, a repeated description thereof will be omitted.

Referring to FIG. 4, according to an embodiment, at least one actuator 410 may discharge airflow for cooling a heat dissipation chamber 450 toward an internal surface 420c of a first case 420. The internal surface 420c of the first case 420 may be opposite to a first chamber surface 420b. For example, a direction (e.g., a -z direction) in which the internal surface 420c of the first case 420 faces may be opposite to a direction (e.g., a +z direction) in which the first chamber surface 420b faces.

According to an embodiment, a protrusion 451 may be bent to have curvature. A portion of the first chamber surface 420b be bent with the curvature. For example, the portion of the first chamber surface 420b may be bent with the curvature in an inside of the heat dissipation chamber 450.

According to an embodiment, the protrusion 451 may include a receiving groove 451a. The receiving groove 451a may be connected to a duct 420a of the inside of the first case 420 surrounding a first surface 410a and a third surface 410c. The receiving groove 451a may be formed by denting the internal surface 420c of the first case 420 opposite to the first chamber surface 420b. For example, the receiving groove 451a may be formed by denting the internal surface 420c of the first case 420 in a direction (e.g., the +z direction) toward the heat dissipation chamber 450. The receiving groove 451a may be in contact with air discharged from the at least one actuator 410. As the protrusion 451 including the receiving groove 451a has a curved shape, a contact area between the airflow discharged from the at least one actuator 410 and the first case 420 may be expanded. As the contact area between the airflow discharged from the actuator 410 and the first case 420 is expanded, the time for the at least one actuator 410 to cool the heat dissipation chamber 450 may be reduced. According to an embodiment, the receiving groove 451a may extend to an outside of the first case 420. For example, the receiving groove 451a may extend in a direction (e.g., a +y direction) substantially parallel to the first surface 410a in the duct 420a. For example, as the receiving groove 451a extends to the outside of the first case 420, the receiving groove 451 may guide movement of the airflow discharged from the at least one actuator 410 to the outside of the first case 420.

Although not illustrated in FIG. 4, the first case 420 may include a plurality of grooves and/or a plurality of protrusions for expanding the contact area between the at least one actuator 410 and the first case 420. The plurality of grooves and/or the plurality of protrusions may be disposed on the internal surface 420c of the first case 420. For example, the plurality of grooves and/or the plurality of protrusions may have a shape extending along a direction (e.g., a +z direction) in which the first surface 410a faces. For example, the plurality of grooves and/or the plurality of protrusions may have a shape extending along a direction (e.g., a -z direction) opposite to the direction in which the first surface 410a faces. However, it is not limited thereto.

As described above, according to an embodiment, the electronic device (e.g., the electronic device 101 of FIG. 1, FIG. 2A, and/or FIG. 2B) may provide a structure capable of reducing time for cooling the heat dissipation chamber 450 by the receiving groove 451a formed in the protrusion 451. According to an embodiment, the electronic device 101 may provide a structure in which the movement of the airflow from the inside of the first case 420 to the outside of the first case 420 is smooth by the receiving groove 451a extending to the outside of the first case 420.

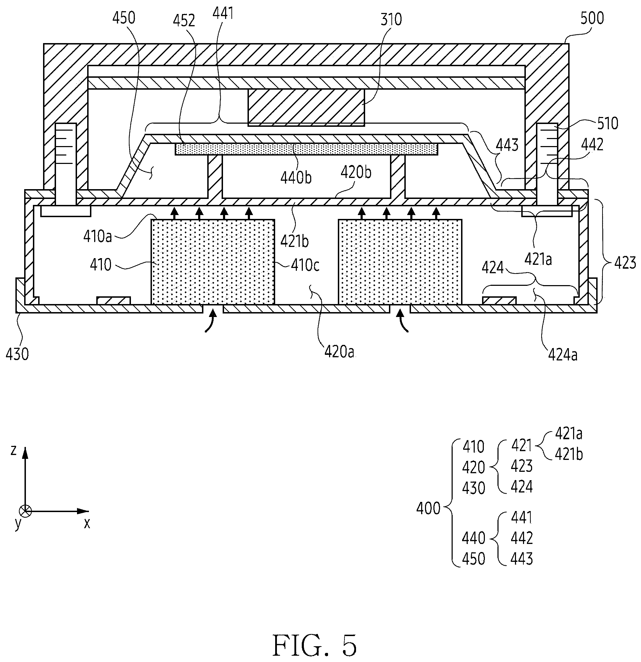

FIG. 5 is a cross-sectional view of a heat dissipation structure and a printed circuit board of an exemplary electronic device according to an embodiment.

Since a heat dissipation structure 400 of FIG. 5 may be a heat dissipation structure 400 in which structures of a first case 420 and a second case 440 are changed in the heat dissipation structure of FIGS. 3A and 3B, a repeated description thereof will be omitted.

Referring to FIG. 5, the first case 420 may include a first coupling portion 421, a third coupling portion 423, and/or a fourth coupling portion 424. According to an embodiment, a portion 421a of the first coupling portion 421 may be in contact with the second case 440. The portion 421a of the first coupling portion 421 may be disposed outside a heat dissipation chamber 450. Another portion 421b of the first coupling portion 421 may be in contact with the heat dissipation chamber 450. The another portion 421b of the first coupling portion 421 may define a first chamber surface 420b of the first case 420. For example, the first chamber surface 420b may be disposed (or included) in the another portion 421b of the first coupling portion 421.

According to an embodiment, the fourth coupling portion 424 may include an insertion hole 424a. The insertion hole 424a may penetrate the fourth coupling portion 424. A cross-sectional area of the insertion hole 424a may have a size corresponding to a cross-sectional area of a fastening member 510. The fastening member 510 may pass through the insertion hole 424a during a process of manufacturing the heat dissipation structure 400. For example, before the first case 420 and a cover 430 are coupled, the fastening member 510 may pass through the insertion hole 424a.

According to an embodiment, the second case 440 may include a first extension portion 441, a second extension portion 442, and/or a third extension portion 443. The first extension portion 441 may be in contact with the heat dissipation chamber 450. The first extension portion 441 may be spaced apart from the first case 420. For example, the first extension portion 441 may be spaced apart from the first case 420 along a direction (e.g., a +z direction) in which a first surface 410a of at least one actuator 410 faces. For example, the first extension portion 441 may define a second chamber surface 440b of the second case 440. The second chamber surface 440b may be disposed (or included) in the first extension portion 441. According to an embodiment, the first extension portion 441 may be substantially parallel to the first surface 410a. For example, the first extension portion 441 may be substantially parallel to the first coupling portion 421 (e.g., the another portion 421b of the first coupling portion 421) of the first case 420.

According to an embodiment, the second extension portion 442 may seal the heat dissipation chamber 450 together with the first case 420. The second extension portion 442 may be in contact with the first case 420. For example, the second extension portion 442 may be in contact with the portion 421a of the first coupling portion 421. For example, the second extension portion 442 may be disposed on the portion 421a of the first coupling portion 421. According to an embodiment, the second extension portion 442 may be parallel to the first surface 410a. For example, the second extension portion 442 may be parallel to the first coupling portion 421.

According to an embodiment, the third extension portion 443 may seal the heat dissipation chamber 450 together with the second extension portion 442. The third extension portion 443 may connect the first extension portion 441 and the second extension portion 442. For example, the third extension portion 443 may extend from the first extension portion 441 to the second extension portion 442. According to an embodiment, the third extension portion 443 may be inclined with respect to the first extension portion 441. The third extension portion 443 may be inclined with respect to the second extension portion 442. For example, the third extension portion 443 may extend along a direction inclined with respect to a direction in which the first surface 410a faces. However, it is not limited thereto. For example, the third extension portion 443 may extend in a direction substantially perpendicular to the first extension portion 441.

According to an embodiment, the fastening member 510 may penetrate a portion of the second case 440 and the first case 420 in contact with a portion of the second case 440. As the fastening member 510 penetrates the first case 420 and the second case 440, the second case 440 and a support portion 500 may be coupled to each other. For example, the fastening member 510 may penetrate the portion 421a of the first coupling portion 421 and a portion of the second extension portion 442. According to an embodiment, the fastening member 510 may be disposed inside the first case 420. For example, the fastening member 510 may be disposed in a duct 420a of the first case 420 surrounding at least a portion of the first surface 410a and the third surface 410c. As the fastening member 510 penetrates the first case 420, the second case 440, and the support portion 500, the heat dissipation structure 400 may be assembled in the electronic device (e.g., the electronic device 101 of FIGS. 1, 2A, and 2B).

As described above, according to an embodiment, the electronic device 101 may provide a structure capable of securing a space in which components in the electronic device 101 are disposed while cooling the electronic device 101 by the first case 420 defining the duct 420a and sealing the heat dissipation chamber 450.

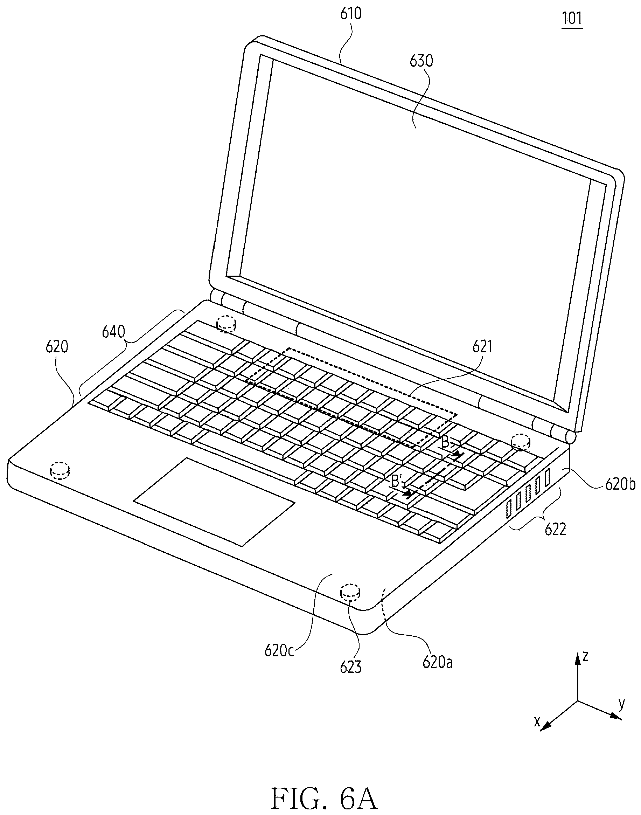

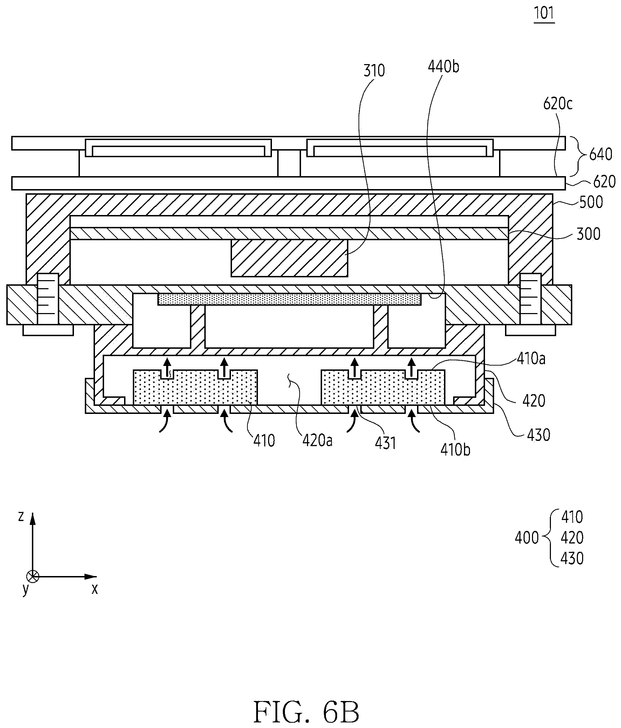

FIG. 6A is a perspective view of an exemplary electronic device according to an embodiment, and FIG. 6B is a cross-sectional view illustrating an example of an exemplary electronic device according to an embodiment, cut along line B-B' of FIG. 6A.

Referring to FIGS. 6A and 6B, according to an embodiment, an electronic device 101 may include a printed circuit board 300, a heat dissipation structure 400, a support portion 500, a first housing 610, a second housing 620, a display 630 (e.g., at least one display 240 of FIGS. 2A and 2B), and/or a keyboard 640. According to an embodiment, the electronic device 101 of FIGS. 6A and 6B may be referred to as a notebook. The electronic device 101 of FIGS. 6A and 6B may be an example of the electronic device 101 illustrated in FIG. 1. However, a shape of the electronic device 101 may not be limited thereto.

According to an embodiment, the first housing 610 may support the display 630. The first housing 610 may be coupled to the display 630. According to an embodiment, the first housing 610 may be movable with respect to the second housing 620. For example, the first housing 610 may be rotatable with respect to the second housing 620. For example, the first housing 610 may be pivotable with respect to the second housing 620.

According to an embodiment, the second housing 620 may accommodate components in the electronic device 101. For example, the second housing 620 may accommodate the printed circuit board 300, the heat dissipation structure 400, and/or the support portion 500. According to an embodiment, the second housing 620 may include a first vent hole 621 and a second vent hole 622. The first vent hole 621 may penetrate the second housing 620. The first vent hole 621 may provide a path through which air may be introduced into the second housing 620 from an outside of the electronic device 101. According to an embodiment, the first vent hole 621 may be disposed on a bottom surface 620a of the second housing 620. The bottom surface 620a of the second housing 620 may mean a surface of the second housing 620 facing a place where the electronic device 101 is mounted. For example, the bottom surface 620a of the housing 620 may be spaced apart from the place where the electronic device 101 is mounted by a protrusion 623 disposed on the bottom surface 620a in contact with the place where the electronic device 101 is mounted. The second vent hole 622 may penetrate the second housing 620. The second vent hole 622 may provide a path through which air may be discharged from the second housing 620 to the outside of the electronic device 101. According to an embodiment, the second vent hole 622 may be disposed on a lateral surface 620b of the second housing 620. The lateral surface 620b of the second housing 620 may be disposed between a front surface 620c of the second housing 620 in which the keyboard 640 is disposed and the bottom surface 620a of the second housing 620. However, a position of the first vent hole 621 and the second vent hole 622 is not limited by the description. For example, the first vent hole 621 may be disposed on at least one of the bottom surface 620a, the lateral surface 620b, and the front surface 620c of the second housing 620. For example, the second vent hole 622 may be disposed on at least one of the bottom surface 620a, the lateral surface 620b, and the front surface 620c of the second housing 620.

According to an embodiment, the display 630 may be configured to provide visual information. The display 630 may be disposed on the first housing 610. For example, the display 630 may be movable together with the first housing 610 when the first housing 610 rotates with respect to the second housing 620.

According to an embodiment, the keyboard 640 may be configured to receive an input from a user. For example, the keyboard 640 may be configured to receive a physical input of the user. The electronic device 101 (or the processor 120 of FIG. 1) may provide a designated function based on receiving the input of the user through the keyboard 640. According to an embodiment, the keyboard 640 may be disposed on the second housing 620. For example, the keyboard 640 may be disposed on the front surface 620a of the second housing 620.

According to an embodiment, the support portion 500 may be disposed in the second housing 620. The support portion 500 may be enclosed by the second housing 620. The support portion 500 may be surrounded by the second housing 620. For example, the support portion 500 may be disposed under the keyboard 640 disposed in the second housing 620. For example, the support portion 500 may be disposed under the front surface 620c of the second housing 620. The front surface 620c of the second housing 620 may be disposed above the support portion 500. The front surface 620c of the second housing 620 may be disposed on the support portion 500.

According to an embodiment, at least one actuator 410 may generate airflow by vibrating along a direction (e.g., a +z direction) in which the first surface 410a faces or a direction in which the second surface 410b faces. For example, the at least one actuator 410 may generate airflow by vibrating along a direction (e.g., the +z direction) toward the front surface 620c of the housing 620 or a direction (e.g., a -z direction) toward the bottom surface 620a of the housing 620. For example, a frequency of the at least one actuator 410 may be approximately 20 kHz or more. As the at least one actuator 410 vibrates at a relatively high frequency, static pressure of the airflow discharged from the at least one actuator 410 may have a relatively high value. As the static pressure of the airflow discharged from the at least one actuator 410 has the relatively high value, the first vent hole 621 may be disposed on another surface of the housing 620 except for the bottom surface 620a of the housing 620. For example, the first vent hole 621 may be disposed on one of the lateral surface 620b and the front surface 620a of the housing 620. For example, as the first vent hole 621 is disposed on one of the lateral surface 620b and the front surface 620a of the housing 620, a height of the protrusion 623 disposed on the bottom surface 620a of the housing 620 may be reduced. The height of the protrusion 623 may mean a length in which the protrusion 623 extends along a direction (e.g., a -z direction) in which the bottom surface 620a of the housing 620 faces.

According to an embodiment, a duct 420a may be connected to the second vent hole 622 of the second housing 620. For example, air introduced along the first vent hole 621 of the second housing 620 may be delivered to the at least one actuator 410 through at least one inlet 431. The air introduced into a cover 430 along the at least one inlet 431 may move along the duct 420a after being delivered to a first case 420 through the airflow generated by the at least one actuator 410. The airflow moving along the duct 420a may move to the outside of the electronic device 101 through the second vent hole 622. As the air introduced through the first vent hole 621 moves to the outside of the electronic device 101 through the second vent hole 622, heat generated from an electronic component 310 disposed on the printed circuit board 300 may be cooled.

Among electronic components, heat generated from an electronic component having a relatively high calorific value may be concentrated in a region of the electronic device. In case that the heat is concentrated in the electronic device, the electronic device may include a component for dispersing the heat in the electronic device, since performance of the electronic components may be reduced. The electronic device may include a component for cooling the electronic device to maintain a temperature inside the electronic device in an appropriate range. As the component for dispersing the heat and the component for cooling the electronic device are disposed in the electronic device, a size of a space in which various electronic components may be disposed in the electronic device may be decreased. The electronic device may need a structure for dispersing and/or cooling the heat in the electronic device while securing the space in which the components may be disposed.

A technical problem to be achieved in this document are not limited to the technical problem described above, and other technical problems not mentioned will be clearly understood by those having ordinary knowledge in the art to which the present disclosure belongs, from the following description.

According to an embodiment, an electronic device (e.g., the electronic device 101 of FIGS. 1, 2A, and 2B) may comprise a printed circuit board (e.g., the printed circuit board 300 of FIG. 3A and FIG. 3B) including an outer surface (e.g., the outer surface 300a of FIG. 3A and FIG. 3B) on which an electronic component (e.g., the electronic component 310 of FIG. 3A and FIG. 3B) is disposed. According to an embodiment, the electronic device may comprise an actuator (e.g., the actuator 410 of FIG. 3A and FIG. 3B) including a first surface (e.g., the first surface 410a of FIG. 3A and FIG. 3B) facing the outer surface of the printed circuit board, a second surface (e.g., the second surface 410b of FIG. 3A and FIG. 3B) opposite the first surface, and a third surface (e.g., the third surface 410c of FIG. 3A and FIG. 3B) connecting the first surface and the second surface. According to an embodiment, the electronic device may comprise a first case (e.g., the first case 420 of FIG. 3A and FIG. 3B), spaced apart from the first surface and the third surface, surrounding at least a portion of the first surface and the third surface. According to an embodiment, the electronic device may comprise a second case (e.g., the second case 440 of FIG. 3A and FIG. 3B), disposed between the printed circuit board and the first case, having a portion that contacts the first case. According to an embodiment, the electronic device may comprise a heat dissipation chamber (e.g., the heat dissipation chamber 450 of FIG. 3A and FIG. 3B), sealed by the first case and the second case so as to disperse heat transferred from the electronic component to the second case. According to an embodiment, the actuator may be configured to deliver air from an outside of the first case toward the first case that partially seals the heat dissipation chamber.

According to an embodiment, the electronic device may provide a structure capable of dissipating heat from the electronic device while securing a space in which components in the electronic device may be disposed by the first case defining a duct that guides movement of airflow and partially sealing the heat dissipation chamber.

According to an embodiment, the electronic device may comprise a cover (e.g., the cover 430 of FIG. 3A and FIG. 3B) including at least one inlet (e.g., at least one inlet 431 of FIG. 3A and FIG. 3B), coupled to the first case so as to be disposed on the second surface. According to an embodiment, the actuator may be configured to deliver the air introduced through the at least one inlet toward the first case.

According to an embodiment, the electronic device may provide, by the actuator that generates airflow through the air introduced through the at least one inlet, a structure capable of cooling an inside of the electronic device.

According to an embodiment, the electronic device may comprise a support portion (e.g., the support portion 500 of FIG. 3A and FIG. 3B) accommodating the printed circuit board. According to an embodiment, the electronic device may comprise a fastening member (e.g., the fastening member 510 of FIG. 3B), coupling the second case to the support portion by passing through another portion of the second case, disposed outside the first case.

According to an embodiment, the electronic device may provide a structure in which the second case may be assembled in the electronic device by the fastening member fastening the support portion and the second case.

According to an embodiment, the electronic device may comprise a support portion (e.g., the support portion 500 of FIG. 5) accommodating the printed circuit board. According to an embodiment, the electronic device may comprise a fastening member (e.g., the fastening member 510 of FIG. 5) coupling the second case to the support portion by passing through the portion (e.g., the second coupling portion 442 of FIG. 5) of the second case and a portion (e.g., the first coupling portion 441 of FIG. 5) of the first case that is in contact with the portion of the second case.

According to an embodiment, the electronic device may provide a structure in which the second case may be assembled in the electronic device by the fastening member fastening the support portion and the second case.

According to an embodiment, a portion of the fastening member may be disposed in an internal space (e.g., the duct 420a of FIG. 3A and FIG. 3B) of the first case that surrounds at least a portion of the first surface and the third surface.

According to an embodiment, the electronic device may provide a structure in which the second case may be assembled in the electronic device by the fastening member fastening the support portion and the second case.

According to an embodiment, the actuator may vibrate along a direction in which the first surface faces or a direction in which the second surface faces, so as to deliver the air toward the first case.

According to an embodiment, the electronic device may provide a structure capable of cooling the heat dissipation chamber by the actuator vibrating in a direction perpendicular to the first surface.

According to an embodiment, the first case may include a first chamber surface (e.g., the first chamber surface 420b of FIG. 3B), facing in a direction parallel to the direction in which the first surface faces, disposed inside the heat dissipation chamber. According to an embodiment, the heat dissipation chamber may include a protrusion (e.g., the protrusion 451 of FIG. 3B) protruding from the first chamber surface.

According to an embodiment, the electronic device may provide a structure capable of reducing damage to the heat dissipation chamber due to air pressure inside the heat dissipation chamber by the protrusion protruding from the first chamber surface.

According to an embodiment, the electronic device may comprise an absorbing member (e.g., the absorbing member 452 of FIG. 3B) disposed on a second chamber surface (e.g., the second chamber surface 440b of FIG. 3B) of the second case, the second chamber surface facing the first chamber surface inside the heat dissipation chamber. According to an embodiment, the absorbing member may be supported by the protrusion.

According to an embodiment, the electronic device may provide a structure capable of circulating a fluid in the heat dissipation chamber by the absorption member disposed in the heat dissipation chamber.

According to an embodiment, the protrusion may include a receiving groove (e.g., the receiving groove 451a of FIG. 4) that is connected to an internal space of the first case surrounding the first surface and the third surface, and that contacts the air discharged from the actuator.

According to an embodiment, the electronic device may provide a structure capable of guiding movement of the airflow to the outside of the first case while expanding a contact area between the first case and the airflow discharged from the actuator by the protrusion including a receiving groove.

According to an embodiment, the heat dissipation chamber may include the fluid being vaporizable by the heat transferred from the electronic component.

According to an embodiment, the electronic device may provide a structure capable of dispersing heat transferred from the electronic component by the heat dissipation chamber including the vaporizable fluid.

According to an embodiment, the actuator may include a plurality of actuators, surrounded by the first case, spaced apart from each other.

According to an embodiment, the electronic device may provide a structure capable of efficiently cooling the heat in the electronic device by the plurality of actuators.

According to an embodiment, the second case may include a first extension portion (e.g., the first extension portion 441 of FIG. 5) parallel to the first surface, spaced apart from the first case along a direction in which the first surface faces. According to an embodiment, the second case may include a second extension portion (e.g., the second extension portion 442 of FIG. 5), in contact with the first case, parallel to the first surface. According to an embodiment, the second case may include a third extension portion (e.g., the third extension portion 443 of FIG. 5), disposed between the first extension portion and the second extension portion, inclined with respect to the first extension portion.

According to an embodiment, the electronic device may provide various structures capable of sealing the heat dissipation chamber by the first case and the second case partially in contact with each other.

According to an embodiment, the first case may include a first coupling portion (e.g., the first coupling portion 421 of FIG. 3A and FIG. 3B), extending in a direction parallel to the first surface, partially covering the first surface. According to an embodiment, the first case may include a second coupling portion (e.g., the second coupling portion 422 of FIG. 3A and FIG. 3B), extending from the first coupling portion along a direction in which the first surface faces, being in contact with the portion of the second case. According to an embodiment, the first case may comprise a third coupling portion (e.g., the third coupling portion 423 of FIG. 3A and FIG. 3B), surrounding at least a portion of the third surface by extending from the first coupling portion along a direction in which the second surface faces.

According to an embodiment, the electronic device may provide various structures capable of sealing the heat dissipation chamber by the first case and the second case partially in contact with each other.

According to an embodiment, the first case may include a fourth coupling portion (e.g., the fourth coupling portion 424 of FIG. 3A and FIG. 3B) connected to the third coupling portion, parallel to the first coupling portion.

According to an embodiment, the electronic device may provide a structure in which the coupling between the first case and the cover is stably maintained by expanding a contact area between the first case and the cover by the fourth coupling portion contacting the cover.

According to an embodiment, the actuator may include at least one nozzle (e.g., at least one nozzle 411 of FIG. 3A and FIG. 3B), penetrating the first surface, and through which the air is discharged.

According to an embodiment, the electronic device may provide a structure capable of cooling heat in the electronic device by the actuator that discharges the airflow through the at least one nozzle.

According to an embodiment, an electronic device (e.g., the electronic device 101 of FIGS. 1, 2A, and 2B) may comprise a printed circuit board (e.g., the printed circuit board 300 of FIG. 3A and FIG. 3B) including an outer surface (e.g., the outer surface 300a of FIG. 3A and FIG. 3B) on which an electronic component (e.g., the electronic component 310 of FIG. 3A and FIG. 3B) is disposed. According to an embodiment, the electronic device may comprise an actuator (e.g., the actuator 410 of FIG. 3A and FIG. 3B) including a first surface (e.g., the first surface 410a of FIG. 3A and FIG. 3B) facing the outer surface of the printed circuit board, a second surface (e.g., the second surface 410b of FIG. 3A and FIG. 3B) opposite the first surface, and a third surface (e.g., the third surface 410c of FIG. 3A and FIG. 3B) connecting the first surface and the second surface. According to an embodiment, the electronic device may comprise a first case including a first coupling portion (e.g., the first coupling portion 421 of FIG. 3A and FIG. 3B), parallel to the first surface, partially covering the first surface, a second coupling portion (e.g., the second coupling portion 422 of FIG. 3A and FIG. 3B) extending from the first coupling portion along a direction in which the first surface faces, and a third coupling portion (e.g., the third coupling portion 423 of FIG. 3A and FIG. 3B) surrounding at least a portion of the third surface by extending from the first coupling portion along a direction in which the second surface faces. According to an embodiment, the electronic device may comprise a second case (e.g., the second case 440 of FIG. 3A and FIG. 3B), disposed between the printed circuit board and the first case, partially contacting the first case. According to an embodiment, the electronic device may comprise a heat dissipation chamber (e.g., the heat dissipation chamber 450 of FIG. 3A and FIG. 3B) sealed by the first case and the second case so as to disperse heat transferred from the electronic component to the second case. According to an embodiment, the electronic device may comprise a cover (e.g., the cover 430 of FIG. 3A and FIG. 3B), including at least one inlet (e.g., at least one inlet 431 of FIG. 3A and FIG. 3B), coupled to the second coupling portion so as to be disposed on the second surface. According to an embodiment, the actuator may vibrate so as to deliver air from an outside of the first case toward the first case that partially seals the heat dissipation chamber.

According to an embodiment, the electronic device may provide a structure capable of dissipating heat from the electronic device while securing the space in which components in the electronic device may be disposed by the first case defining the duct that guides the movement of the airflow and partially sealing the heat dissipation chamber.

According to an embodiment, the electronic device may comprise a support portion (e.g., the support portion 500 of FIG. 3A and FIG. 3B) accommodating the printed circuit board. A fastening member (e.g., the fastening member 510 of FIG. 3B), coupling the second case to the support portion by passing through another portion of the second case, may be disposed outside the first case.

According to an embodiment, the electronic device may provide a structure in which the second case may be assembled in the electronic device by the fastening member fastening the support portion and the second case.

According to an embodiment, the electronic device may comprise a support portion (e.g., the support portion 500 of FIG. 5) accommodating the printed circuit board. According to an embodiment, the electronic device may comprise a fastening member (e.g., the fastening member 510 of FIG. 5) coupling the second case to the support portion by passing through the portion (e.g., the second extension portion 442 of FIG. 5) of the second case and a portion (e.g., the first coupling portion 441 of FIG. 5) of the first case in contact with the portion of the second case.

According to an embodiment, the electronic device may provide a structure in which the second case may be assembled in the electronic device by the fastening member fastening the support portion and the second case.

According to an embodiment, the first case may include a first chamber surface (e.g., the first chamber surface 420b of FIG. 3B), facing in a direction parallel to a direction in which the first surface faces, disposed inside the heat dissipation chamber. According to an embodiment, the heat dissipation chamber may include a protrusion (e.g., the protrusion 451 of FIG. 3B) protruding from the first chamber surface.

According to an embodiment, the electronic device may provide a structure capable of reducing damage to the heat dissipation chamber due to air pressure inside the heat dissipation chamber by the protrusion protruding from the first chamber surface.

According to an embodiment, the second case may include a first extension portion (e.g., the first extension portion 441 of FIG. 5), parallel to the first surface, spaced apart from the first case along a direction in which the first surface faces. According to an embodiment, the second case may include a second extension portion (e.g., the second extension portion 442 of FIG. 5), in contact with the first case, parallel to the first surface. According to an embodiment, the second case may include a third extension portion (e.g., the third extension portion 443 of FIG. 5), disposed between the first extension portion and the second extension portion, inclined with respect to the first extension portion.

According to an embodiment, the electronic device may provide various structures capable of sealing the heat dissipation chamber by the first case and the second case partially in contact with each other.

The effects that may be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101), comprising:
a printed circuit board (300) including an outer surface (300a) on which an electronic component (310) is disposed;
an actuator (410) including a first surface (410a) facing the outer surface (300a) of the printed circuit board (300), a second surface (410b) opposite the first surface (410a), and a third surface (410c) connecting the first surface (410a) and the second surface (410b);
a first case (420), spaced apart from the first surface (410a) and the third surface (410c), surrounding at least a portion of the first surface (410a) and the third surface (410c);
a second case (440), disposed between the printed circuit board (300) and the first case (420), having a portion that contacts the first case (420); and
a heat dissipation chamber (450), sealed by the first case (420) and the second case (440) so as to disperse heat transferred from the electronic component (310) to the second case (440);
wherein the actuator (410) is configured to deliver air from an outside of the first case (420) toward the first case (420) that partially seals the heat dissipation chamber (450).

2. The electronic device (101) of claim 1, further comprising:
a cover (430), including at least one inlet (431), coupled to the first case (420) so as to be disposed on the second surface (410b), and
wherein the actuator (410) is configured to deliver the air introduced through the at least one inlet (431) toward the first case (420).

3. The electronic device (101) of any one of claim 1 or claim 2, further comprising:
a support portion accommodating the printed circuit board (300); and
a fastening member (510), coupling the second case (440) to the support portion by passing through another portion of the second case (440), disposed outside the first case (420).

4. The electronic device (101) of any one of claims 1 to 3, further comprising:
a support portion accommodating the printed circuit board (300); and
a fastening member (510) coupling the second case (440) to the support portion by passing through the portion of the second case (440) and a portion of the first case (420) that is in contact with the portion of the second case (440).

5. The electronic device (101) of any one of claims 1 to 4,
wherein a portion of the fastening member (510) is disposed in an internal space of the first case (420) that surrounds at least a portion of the first surface (410a) and the third surface (410c).

6. The electronic device (101) of any one of claims 1 to 5,
wherein the actuator (410) vibrates along a direction in which the first surface (410a) faces or a direction in which the second surface (410b) faces, so as to deliver the air toward the first case (420).

7. The electronic device (101) of any one of claims 1 to 6, wherein:
the first case (420) includes a first chamber surface (420b), facing in a direction parallel to a direction in which the first surface (410a) faces, disposed inside the heat dissipation chamber (450); and
the heat dissipation chamber (450) includes a protrusion (451) protruding from the first chamber surface (420b).

8. The electronic device (101) of any one of claims 1 to 7, further comprising:
an absorbing member (452) disposed on a second chamber surface (440b) of the second case (440), the second chamber surface (440b) facing the first chamber surface (420b) inside the heat dissipation chamber (450),
wherein the absorbing member (452) is supported by the protrusion (451).

9. The electronic device (101) of any one of claims 1 to 8,
wherein the protrusion (451) includes a receiving groove (451a) that is connected to an internal space of the first case (420) surrounding the first surface (410a) and the third surface (410c), and that contacts the air discharged from the actuator (410).

10. The electronic device (101) of any one of claims 1 to 9,
wherein the heat dissipation chamber (450) includes a fluid being vaporizable by the heat transferred from the electronic component (310).

11. The electronic device (101) of any one of claims 1 to 10,
wherein the actuator (410) includes a plurality of actuators (410), surrounded by the first case (420), spaced apart from each other.

12. The electronic device (101) of any one of claims 1 to 11,
wherein the second case (440) includes
a first extension portion (441), parallel to the first surface (410a), spaced apart from the first case (420) along a direction in which the first surface (410a) faces;
a second extension portion (442), in contact with the first case (420), parallel to the first surface (410a); and
a third extension portion (443), disposed between the first extension portion (441) and the second extension portion (442), inclined with respect to the first extension portion (441).

13. The electronic device (101) of any one of claims 1 to 12,
wherein the first case (420) includes:
a first coupling portion (421), extending in a direction parallel to the first surface (410a), partially covering the first surface (410a);
a second coupling portion (422), extending from the first coupling portion (421) along a direction in which the first surface (410a) faces, being in contact with the portion of the second case (440); and
a third coupling portion (423), surrounding at least a portion of the third surface (410c) by extending from the first coupling portion (421) along a direction in which the second surface (410b) faces.

14. The electronic device (101) of any one of claims 1 to 13,
wherein the first case (420) further includes a fourth coupling portion (424), connected to the third coupling portion (423), parallel to the first coupling portion (421).

15. The electronic device (101) of any one of claims 1 to 14,
wherein the actuator (410) further includes at least one nozzle (411), penetrating the firs t surface (410a), and through which the air is discharged.
